# EUROPEAN PATENT APPLICATION

(11) **EP 4 530 716 A1**
(43) Date of publication of application: **02.04.2025**
(21) Application number: 24195206.8
(22) Date of filing: 19.08.2024
(51) Int. Cl.: G03F 1/40, G03F 1/64

(54) **EUV MASK AND PELLICLE ASSEMBLY**

(30) Priority: 27.09.2023 US 202318373485
(71) Applicant: Intel Corporation, Santa Clara, CA 95054 (US)
(72) Inventor: KIM, Yongbae, San Jose, CA 95125 (US)
(74) Representative: HGF

(57) **Abstract**

Provided is a pellicle assembly that is sufficiently conductive in cooperation with a photomask that is mounted to the pellicle assembly to protect the pellicle and mask from electro static discharge.

## Description

### TECHNICAL FIELD

Embodiments relate to the field of semiconductor die manufacturing, and more particularly, to pellicle assembly structures for photo lithography masks.

### BRIEF DESCRIPTION OF THE DRAWINGS

Figs. 1A and 1B are schematic diagrams illustrating an exemplary pellicle assembly.
Fig. 2 is a schematic diagram illustrating electro-static discharge between a pellicle and a photomask scan surface.
Fig. 3 is a schematic view of a mask/pellicle system with ESD protection in accordance with some embodiments.
Figs. 4A and 4B are schematic diagrams showing another embodiment of an ESD resistant mask and pellicle structure in accordance with some embodiments.
Fig. 5 is a schematic diagram illustrating an embodiment of a pellicle/mask assembly in accordance with some embodiments.
Fig. 6 is a schematic diagram depicting an EUV scan system for fabricating integrated circuit semiconductor dies in accordance with some embodiments.

### DETAILED DESCRIPTION

Extreme ultraviolet (EUV) lithography is an optical lithography technology used in semiconductor device fabrication to make integrated circuits (ICs). Currently, it uses extreme ultraviolet (EUV) wavelengths near 13.5 nm, typically using a laser-pulsed tin (Sn) droplet plasma to produce a pattern by using a reflective photomask to expose targeted photoresist on a semiconductor substrate. It is becoming ever more appreciated that pellicles need to be used with the masks in order to enhance scan operations, as well as to enhance mask longevity. Pellicles, however, that are suitable for EUV applications, are extremely delicate and expensive and thus, improved implementations that are effective and also reduce damage to the pellicle are desired.

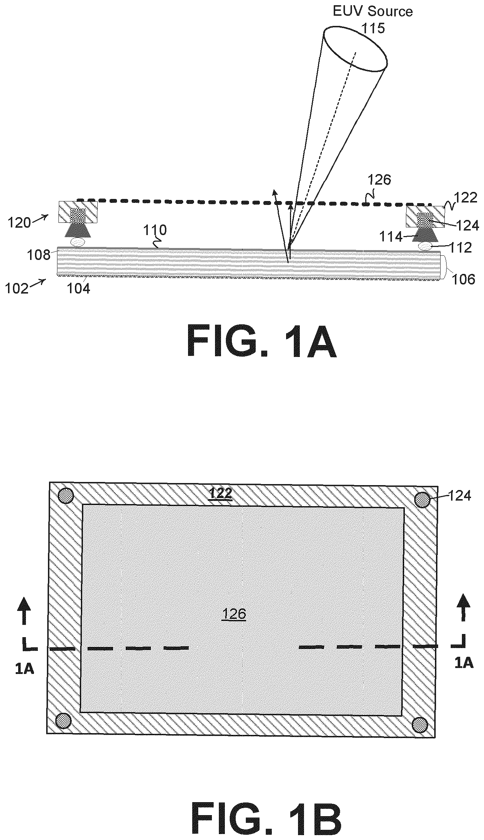

Figs. 1A and 1B are schematic diagrams illustrating an exemplary pellicle assembly. Fig. 1B is an underside view showing the pellicle, while Fig. 1A is a cross-sectional view of the pellicle-mask assembly taken from a view along line 1A-1A. (Note that these are schematic views, not to precise scale and not showing every feature.) The assembly includes an EUV mask 102 and a pellicle 120 mounted to the mask. Also shown is an EUV source 115 for projecting EUV radiation onto the scan surface of the mask 102 through the pellicle 120.

The EUV photomask 102 is a sophisticated multi-layer film stack generally including multiple reflector layers 106 disposed atop a low thermal expansion material (LTEM) substrate 104. It also includes a cap layer 108 disposed atop the reflector layers 106, and an EUV absorption layer 110 disposed atop the cap layer 108. (Note that the term "atop" is relative in that it connotes a relative position of a layer within a stack of multiple layers, but in absolute terms, a layer that is "atop" another layer may actually be below, above, rightward, leftward, etc. to the other layer, depending on the position of the stack in absolute space.)

The reflector layers 106 typically include between 40 and 50 alternating layers of silicon and molybdenum deposited on the LTEM substrate 104 to act as a Bragg reflector that maximizes the reflection of the EUV wavelength. The multi-layer reflector 106 is capped with the cap layer 108 to prevent oxidation and also as a etch stopping layer against the plasma etch process that forms patterns of the absorber layer 110, typically using a thin layer of ruthenium. The absorption layer (or absorber) 110, which typically functions as the mask's incident scan surface, serves to absorb the EUV radiation into the reflector stack. In some configurations, it may be implemented with a tantalum boron nitride film or a tantalum nitride topped with a thin anti-reflective material. Absorbers are typically designed to have nearly zero etch bias enabling very fine feature resolution. The backside of the substrate may have a conductive coating (not specifically illustrated) composed, for example, of chrome nitride.

The pellicle 120 includes a frame 122, rectangular shaped in this example, and fixtures 124 to be removably mounted to the mask through studs 114, which in turn, are mounted to an outer region of the mask's scan surface through adhesive connections 112. The frame 122 also houses a pellicle membrane 126, which is mounted on the frame. The membrane is used for protecting the mask (also referred to as a reticle) during the EUV scan process. Among other things, the pellicle membrane, which is typically positioned 2 to 3 mm above the mask's scan surface, blocks particles, which if landing on the scan surface during a scan operation, would likely result in faulty patterning and thus chip failure and lower production yield. Unfortunately, in order to work properly, a pellicle membrane must allow a sufficient amount of the EUV radiation through to the mask. For example, most EUV scan systems require 90% or more radiation transmission through the pellicle. Accordingly, pellicle membranes are usually extremely thin making them fragile, especially in view of the high energy, high temperature and corrosive vacuum environments to which they are exposed. As well as protecting a mask during scanning, a pellicle is normally also expected to protect the mask from particles or other contaminants during transport, entry into or exit from the exposure chamber. Pellicle membranes can be damaged for a variety of understood causes including heating, exposure to plasmas and mechanical stresses, e.g., when subjected to the pressure changes before, during and after scan operations. However, even when these issues are addressed, pellicle membranes could be damaged by the non-uniform surface charges on the pellicle or on the mask surface e.g., between the pellicle membrane and mask surface or between two locations of the pellicle or of the mask surface.

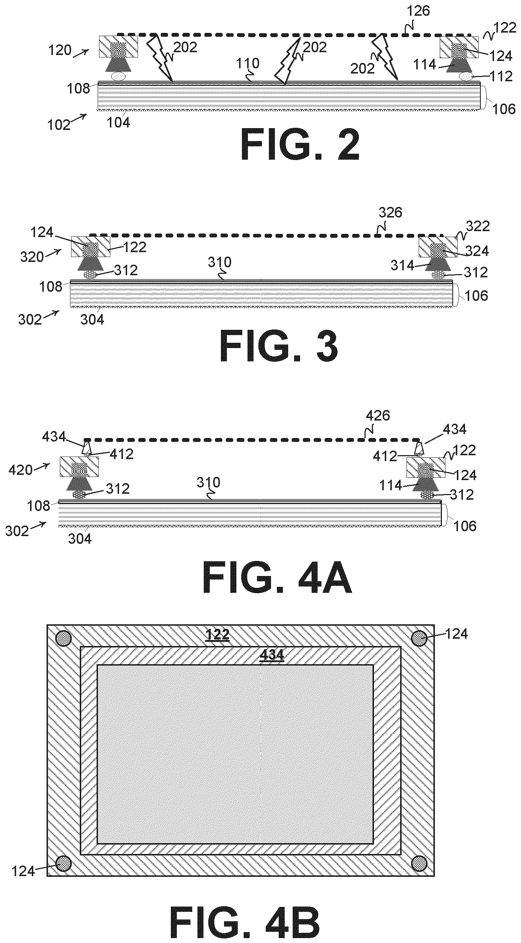

Fig. 2 illustrates and example of how the pellicle can be damaged by the non-uniform surface charges or the surface potential difference between the membrane and the mask surface it has been observed that EUV masks may also incur damage such as pits or tears as a result of electrostatic discharge between the pellicle and mask surfaces. This occurs because pellicle systems have been electrically isolated from the mask, making electrostatic discharge between the pellicle assembly (membrane, frame) and mask surface more likely. It happens as a result of charge imbalance between the pellicle and mask when the pellicle/mask system is transported, loaded onto the scanner, scanned inside the scanner chamber, and unloaded. Several possible discharge paths 202 are shown in Figure 2. The discharge can cause physical damage to the mask 102, as well as to the pellicle membrane 126.

One of the causes of ESD events is static electricity. Static electricity is often generated through tribocharging, the separation of electric charges that occurs when two materials are brought into contact and then separated. Another cause of ESD damage is through electrostatic induction. This occurs when an electrically charged object is placed near a conductive object isolated from the ground. The presence of the charged object creates an electrostatic field that causes electrical charges on the surface of the other object to redistribute. Even though the net electrostatic charge of the object has not changed, it now has regions of excess positive and negative charges. An ESD event may occur when the object comes into contact with a conductive path. For example, charged regions on the surfaces of a mask or pellicle may induce potential between sensitive mask/membrane components via electrostatic induction and an ESD event may occur, for example, when additional charge is accumulated such as during scanning or when objects make contact with the mask/pellicle system. In an EUV scan chamber, ESD may also be caused or exacerbated from energetic charged particles impinging on the mask/pellicle surfaces, which results in deep charging that facilitates favorable conditions for multi-ESD events to occur, damaging the pellicle and/or mask. Even if ESD does not occur yet, i.e., the charge imbalance level is lower than the ESD threshold, the change imbalance between two locations on the pellicle system or the mask surface, e.g., between the membrane and the mask surface, can increase the mechanical stress of the pellicle membrane and eventually lead to membrane damage.

Particles (not shown in the figures) can be added on the pellicle membrane or under the pellicle membrane during the pellicle manufacturing process or during pellicle handling or mask handlining processes including transportation etc. Non-uniform surface charge distribution on the particles or near the particles can be enhanced when the pellicle/mask system is transported, loaded onto the scanner, scanned inside the scanner chamber, and unloaded, which can increase the mechanical stress of the pellicle membrane and eventually result in the pellicle rupture.

Fig. 3 is a schematic view of a mask/pellicle system with ESD protection in accordance with some embodiments. The mask and pellicle are connected to each other so that they are no longer electrically isolated from one another. That is, one or more conductive (or at least electro-statically dissipative) path(s) are formed using conductive assembly mounts between the pellicle assembly and the mask so as to reduce or eliminate charge differences between points on the pellicle membrane and mask thereby preventing or at least reducing harmful electro-static discharge that could otherwise occur.

In the depicted embodiment, the pellicle/mask system includes a pellicle assembly 320 mounted to an EUV photomask 302 using conductive mounts including a conductive adhesive 312 rather than an insulating adhesive for adhering the studs 314 to the mask 302, e.g., at an outer (peripheral) region of the mask's scan surface. In addition to the reflector layers 106 and cap 108, mask 302 includes an absorber 310 and substrate 304 with outer surfaces that can conduct electrical charge. In addition, the contact surface for the studs 314 are configured to conductively and adhesively accommodate the conductive adhesive 312. Similarly, the mask exposure (or scan) surface, e.g., at the absorber, 310 may include materials better suited for electrical conduction, although many existing absorber materials may already be sufficient along these lines. In addition, the frame 322, frame fixtures 324 and pellicle membrane 326 are implemented using sufficiently conductive materials, at least at their surfaces, to facilitate conductive charge flow between the pellicle and mask through the utilized mounts (studs, fixtures, and stud adhesives) rather than charge having to flow between the mask and pellicle as damaging arcs.

As a way of quantifying electrical conductivity for reducing electro-static discharge between the pellicle membrane and mask, in some embodiments, the surface resistivity between a point on the exposed pellicle surface facing the mask and a point on the mask surface facing the pellicle may be used. To be electro-statically conductive, this resistivity should be less than or equal to 1 Meg. Ohm. This will typically provide a sufficient path for electrons to flow freely across the relevant surface portion(s). In some embodiments, it may be sufficient for the pellicle-mask surfaces to be electro-statically dissipative, meaning that the surface resistance between any two facing surface points should be at least less than or equal to about 1000 Meg. Ohms, although the effectiveness of a pellicle/mask assembly being merely electro-statically dissipative will depend on such factors as membrane surface fragility and distance between the membrane and mask facing surfaces.

In the depicted embodiment, pellicle-mask mounts are implemented with stud and fixture connectors. The fixtures align, and removably fasten to the studs when the pellicle is attached to the mask. In this example, the studs are generally conically shaped, making them suited for coupling and alignment. In some implementations, they may be more rigidly secured to each other through any suitable manner such as through a snap connection, a magnetic coupling, friction from deformation, etc. Similarly, while conical shaped studs are shown, any suitable mount geometries may be employed, recognizing that deterministic alignment (lateral and vertical), as well as assembly stability, are typically important. In some embodiments, stud/fixture mounts may not even be used, with the frame instead being connected directly to the mask, e.g., through mount surfaces with features used to align the pellicle with the mask. Along these lines, four stud/fixture pairs are shown but assuming fastener pair mounts are to be used, less or more than four could be employed. It may be desirable to have additional physical connections between the mask and pellicle in order to improve overall conductivity there between. Also, while the pellicle is shown being mounted to the mask at the outer region of the mask's scan surface, it could be mounted to the mask at any suitable location. For example, it could be mounted to sides of the mask through a suitable conductive surface layer, for example, or even onto a common base or substrate that is part of the mask or used to support the mask.

The frame 322 may be formed from any suitable material or material combination with sufficient conductivity, at least on the frame surface(s). However, in some embodiments, the pellicle may be expected to reach in excess of 680 degrees C, well over, for example, the melting point of aluminum. Accordingly, factors such as expected temperature should be considered. Notwithstanding, specific examples of suitable frame materials include aluminum, aluminum alloys, stainless steel, conducting silicon alloys, iron-based alloys, ceramics with conductive coatings, metal-ceramics composite materials, resins, and the like. There will be more flexibility in material selection if the pellicle temperatures can be limited, e.g., with the use of sufficiently EUV transmissive and thermally conductive membranes.

The pellicle membrane 326 should have high transmittance with respect to EUV light, along with mechanical and thermal stability under expected operating conditions. For example, desired EUV scanning at or above 200 W can result in membranes heating to extreme temperatures (e.g., in excess of 500 degrees C), depending on the absorption properties of the membrane. Moreover, wrinkles and other mechanical defects on pellicles can cause scanning nonuniformities due to uneven absorption; which is even worse for smaller wrinkles and more coherent illumination. With these considerations in mind, pellicle membranes should also be sufficiently electrically conductive to inhibit electron accumulation when the pellicle is mounted to a mask. The utilized membrane materials and structures are not particularly limited. For example, one or more layers of the same or of different materials could be used, along with coatings or films, so long as structural integrity and EUV transmission are maintained. Such materials may be organic and/or inorganic materials. Organic materials such as polymers (e.g., fluorine based polymers) may be more resilient and generate less particulate detritus but alone, may not have suitable transmission properties when composed of suitable thicknesses for structural integrity. On the other hand, inorganic materials can have good transmission properties but can be brittle and generate unwanted particulate matter. Some exemplary suitable inorganic materials include crystalline silicon (e.g., monocrystalline, polycrystalline), aluminum nitrides (e.g., layered on a metal mesh), graphene, diamond-like carbon, amorphous carbon, carbon nano-tube structures, and graphites such as nanometer thick graphite (NGF). Of note, NGF materials may have favorable optical, mechanical, thermal, and chemical properties for membrane layer implementations, although they can be susceptible to damage from certain process steps such as hydrogen plasma cleaning. Accordingly, they may be used in combination with other traditional material layers, or coatings, such as with silicon nitrides and silicon/molybdenum/niobium, e.g., as base layers.

In some embodiments, in order to improve static charge dispersion, as well as thermal build-up, membrane structures may include surface layers (above and/or below surfaces) of extremely thin thermally and electrically conductive materials such as platinum group metals (e.g., ruthenium, rhodium, palladium, osmium, iridium, and platinum) achieved, for example, through CMP (chemical mechanical polishing) or grain growth methodologies, just to list a few options. These same metals may also be used for other surface portions of a pellicle/mask structure. They have good conductivity and can be made to withstand high temperatures, as well as corrosion such as oxidation.

The pellicle may be adhered to the mask using any suitable electrically conductive adhesive that can work in cooperation with the materials used for the contacting mask/pellicle surfaces, as well as on environmental conditions under which the adhesive will be exposed. Adhesives generally include a binder and a filler, although they may also or alternatively include combinations of solvents, fillers, plasticizers, reinforcements, thickeners and thixotropic agents, film formers, antioxidants, emulsifiers, and/or wetting agents. Depending on the utilized components, they can be made to be conductive in a variety of ways, although it may be convenient to utilize conductive filler materials to achieve overall adhesive conductivity with the binders and other components chosen for optimal adhesion, stability, and benignity.

Off the shelf or customized adhesives may be suitable. Off-the-shelf conductive adhesives come in a variety of different filler and binder options providing good electrical conductivity levels, strong adhesion properties, and have sufficiently low volatile organic compounds or corrosive by-products. For example, there are epoxy adhesives with silver filler particles.

Alternatively, in some embodiments, an adhesive may be made or otherwise procured for specific pellicle/mask implementations. Such adhesives may be devised using a binder (epoxies, resins, etc.) with infused conductive fillers and in some cases, also using one or more primers, primer coatings, and/or antioxidant agents.

In some embodiments, a conductive adhesive may be formed from a matrix of a plurality of electrically conductive particles distributed in a binder such as a resin (e.g., a polymer resin). Many types of binders are suitable. In some embodiments, binders may be formed from polymeric resins such as polyamide-imide, polyimide, polyvinyl esters and combinations thereof. Suitable carriers for the binders include, for example, propylene glycol methyl ether acetate, N-methyl-2-pyrrolidone, xylene, and combinations thereof. The amount of binder may vary (e.g., 70% to 95%) depending on the amount of conductive particles used in the coating. Generally, a higher binder content is desired for increased adhesion, corrosion resistance, and application but should be weighed against adverse impacts on electro-conductivity.

Utilized binders (resins, epoxies) may be set in any suitable manner. For example, they could be set using heat (e.g., soldering, sintering), pressure, chemical reaction, or agitation (e.g., applied sonic or radiated energy). When thermally set, some suitable resins may include maleic acid imides or epoxies. polymer resin such as polyamide-imide, polyimide, polyvinyl esters and combinations thereof. Suitable carriers for the binders include, for example, propylene glycol methyl ether acetate, N-methyl-2-pyrrolidone, xylene and combinations thereof.

Suitable conductive particle types include but are not limited to copper (Cu), nickel (Ni), aluminum (Al), tin (Sn), zinc (Zn), titanium (Ti), silver (Ag), gold (Au), indium (In), bismuth (Bi), gallium (Ga) and palladium (Pd) or an alloy comprising two or more metals (e.g., alloys employing tin, nickel, and/or indium). Specific implementations will depend on operating environment and material properties o the other pellicle and mask components, although adequate attributes such as good thermal conductivity, electrical conductivity, resistance to ion migration, and desired melting/mixing properties will likely be desirable.

In some embodiments, the utilized particles may even be coated with another, e.g., more electrically conductive particle, e.g., a noble metal such as silver or gold. By doing so, the particle may be less likely to corrode or otherwise oxidize.

Figs. 4A and 4B are schematic diagrams showing another embodiment of an ESD resistant mask and pellicle structure in accordance with some embodiments. This mask and pellicle assembly 420 is similar to the structure of Fig. 3 except that it additionally includes a border structure 434 (rectangular shaped in this example). The border 434 is a rigid structure, similar to the frame, but it is particularly suited for mounting a pellicle membrane 426, which may be made in such a way that requires it to reside on a border structure that may not be ideal for mounting directly to a mask. In such cases, the border may instead be mounted to a frame through conductive adhesive 412 with the frame being mounted to the mask, as discussed above.

For example, in some embodiments, a membrane may be made by growing one or more membrane film layer(s) from a base substrate such as a silicon substrate. For example, the film layer(s) may be formed using CVD (chemical vapor deposition) and/or sputtering. The substrate may then be back-etched beneath the film layer(s) within an inner region but leaving a peripheral portion to function as a supporting border, which may then be mounted to a frame. If the border itself is not sufficiently conductive, a conductive material may be applied to its outer surfaces in sufficient contact with the membrane outer surface(s).

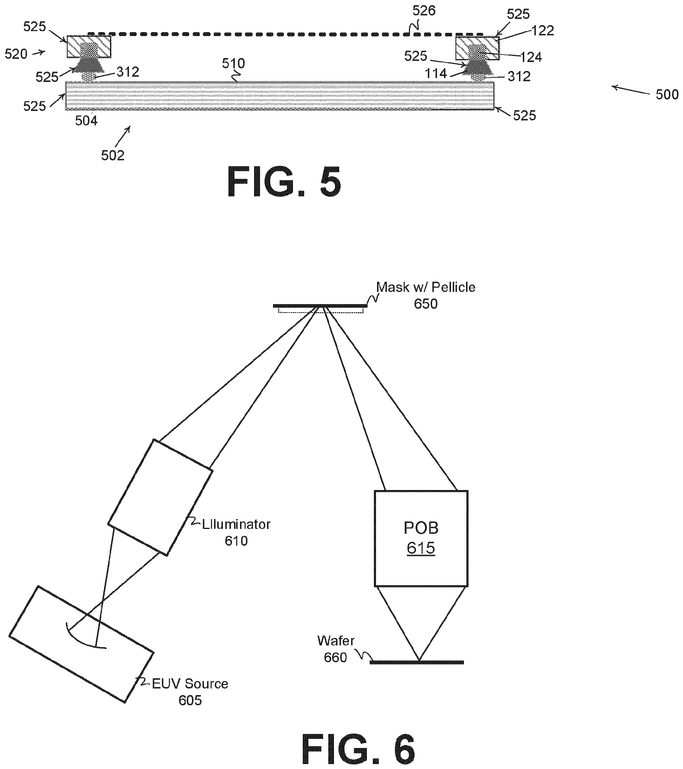

Fig. 5 is a schematic diagram illustrating an embodiment of a pellicle/mask assembly in accordance with some embodiments. This structure is similar to the structure of Fig. 3 except that it expressly illustrates the addition of a conductive material 525 onto selected portions of the pellicle/mask assembly. For example, a protective and electrically conductive film may be formed on the selected surface portions such as on the mask edges and mounting surfaces, mounting structures (e.g., studs/fixtures) if appropriate, frame edges, and border edges (not shown). For example, the film may not only be conductive, but also, it may provide resistance against corrosives such as hydrogen radicals present in exposure environments and EUV radiation.

Fig. 6 is a schematic diagram depicting an EUV scan system for fabricating integrated circuit semiconductor dies in accordance with some embodiments. The system generally includes an EUV source 605, an illuminator 610, and a projection optics box (POB) 615 for lithographically scanning nano-order features into a semiconductor wafer 660 using a mask (with pellicle) 650 as indicated. The EUV source 605 generates EUV radiation provided to the illuminator 610, which forms a pupil shape to illuminate the right amount of light for the EUV mask 650. The mask reflects the EUV radiation in accordance with feature patterns defined within the mask's reflector layer stack. The reflected EUV pattern is then imaged onto a portion of the wafer through the POB. From here, the wafer (and mask in some cases) are moved to a new position, and the process is repeated. In this way, nano-scale "cuts" can be applied to the wafer to define nano-feature elements such as fins, gates, metal lines, and the like.

Illustrative examples of the technologies disclosed herein are provided below. An embodiment of the technologies may include any one or more, and any compatible combination of, the examples described below.

Example 1 is an apparatus that includes a pellicle assembly and assembly mounts. The pellicle assembly has a membrane, and it is to be mounted to a photomask (mask) that has a scan surface with an outer region. The assembly mounts are used to attach the pellicle assembly to the mask at the outer region. They also facilitate sufficient electrical conductivity between the pellicle membrane and mask scan surface to at least be electro statically dissipative between the mask and pellicle assembly when the mask and pellicle assembly are attached to one another.

Example 2 includes the subject matter of example 1, and wherein the assembly mounts facilitate sufficient conductivity between the mask and pellicle assembly to achieve electrical conductivity between the mask and pellicle assembly.

Example 3 includes the subject matter of any of examples 1 and 2, and wherein the one or more assembly mounts include conductive fasteners to be adhered to the mask at the outer region through a conductive adhesive.

Example 4 includes the subject matter of any of examples 1-3, and wherein the conductive adhesive includes a binder with conductive filler particles.

Example 5 includes the subject matter of any of examples 1-4, and wherein the conductive filler particles include silver particles or platinum group metal particles.

Example 6 includes the subject matter of any of examples 1-5, and wherein the conductive filler particles include material particles coated with a platinum group metal film.

Example 7 includes the subject matter of any of examples 1-6, and wherein the one or more assembly mounts include conductive stud/fixture pair fasteners.

Example 8 includes the subject matter of any of examples 1-7, and wherein a stud from the stud/fastener pair is to be adhered to the mask, and a fastener from the stud/fastener pair is part of the pellicle assembly.

Example 9 includes the subject matter of any of examples 1-8, and wherein the membrane is mounted to a frame that is to be connected to the photomask outer region through the assembly mounts.

Example 10 includes the subject matter of any of examples 1-9, and wherein the frame is formed from a substrate used to build the membrane.

Example 11 includes the subject matter of any of examples 1-10, and wherein the membrane is mounted to a border structure that is mounted to a frame through conductive adhesive mounts, the frame to be connected to the photomask outer region through the assembly mounts.

Example 12 includes the subject matter of any of examples 1-11, and wherein the border is formed from a substrate used to build the membrane.

Example 13 includes the subject matter of any of examples 1-12, and wherein the photomask is an EUV reflector mask.

Example 14 is an EUV scan system that has an EUV radiation source, an illuminator to illuminate the EUV radiation onto a pellicle/photomask assembly that is in accordance with any of examples 1-13, a photo optics box to receive radiation reflected from the photomask, and a wafer platform to support a semiconductor wafer to be scanned by radiation from the photo optics box.

Example 15 is an apparatus that includes a photomask and a pellicle assembly. The photomask has a scan surface. The pellicle assembly has a membrane and is mountable to the photomask to pass EUV light through the membrane to the scan surface. The pellicle assembly is mountable to the photomask through one or more assembly mounts, and there is sufficient electrical conductivity between the pellicle membrane and mask scan surface to at least be electro statically dissipative between the mask and pellicle assembly when the pellicle assembly is mounted to the photomask.

Example 16 includes the subject matter of example 15, and wherein the assembly mounts facilitate sufficient conductivity between the mask and pellicle assembly to achieve electrical conductivity between the mask and pellicle assembly.

Example 17 includes the subject matter of any of examples 15-16, and wherein the one or more assembly mounts include conductive fasteners to be adhered to the mask through a conductive adhesive.

Example 18 includes the subject matter of any of examples 15-17, and wherein the conductive adhesive includes a binder with conductive filler particles.

Example 19 includes the subject matter of any of examples 15-18, and wherein the conductive filler particles include silver particles or platinum group metal particles.

Example 20 includes the subject matter of any of examples 15-19, and wherein the conductive filler particles include material particles coated with a platinum group metal film.

Example 21 includes the subject matter of any of examples 15-20, and wherein the one or more assembly mounts include conductive stud/fixture pair fasteners.

Example 22 includes the subject matter of any of examples 15-21, and wherein a stud from the stud/fastener pair is to be adhered to the mask, and a fastener from the stud/fastener pair is part of the pellicle assembly.

Example 23 includes the subject matter of any of examples 15-22, and wherein the membrane is mounted to a frame that is to be connected to the photomask through the assembly mounts.

Example 24 includes the subject matter of any of examples 15-23, and wherein the frame is formed from a substrate used to build the membrane.

Example 25 includes the subject matter of any of examples 15-24, and wherein the membrane is mounted to a border structure that is mounted to a frame through conductive adhesive mounts, the frame to be connected to the photomask through the assembly mounts.

Example 26 includes the subject matter of any of examples 15-25, and wherein the border is formed from a substrate used to build the membrane.

Example 27 includes the subject matter of any of examples 15-26, and wherein the photomask is an EUV reflector mask.

Example 28 is an EUV scan system that has an EUV radiation source, an illuminator to illuminate the EUV radiation onto a pellicle/photomask assembly that is structured in accordance with any of examples 15-27, a photo optics box to receive radiation reflected from the photomask, and a wafer platform to support a semiconductor wafer to be scanned by radiation from the photo optics box.

Example 29 includes the subject matter of any of examples 15-27, and wherein the membrane includes at least one outer conductive film surface.

Example 30 is a system that includes a pellicle/photomask assembly, an illuminator, an EUV radiation source, and a wafer platform. The photomask (mask) has a pellicle assembly and a scan surface. The pellicle assembly has a membrane and is mounted to the mask to pass EUV light through the membrane to the mask scan surface. The pellicle assembly is mounted to the mask through one or more assembly mounts such that there is sufficient electrical conductivity between the pellicle membrane and mask scan surface for electro-static dissipation. The illuminator is to illuminate the EUV radiation through the membrane onto the mask scan surface. The wafer platform supports a semiconductor wafer to be scanned.

Example 31 includes the subject matter of example 30, and further comprises a photo optics box to receive radiation reflected from the photomask and to direct it onto the mask scan surface.

Example 32 includes the subject matter of any of examples 30-31, and wherein there is sufficient electrical conductivity between the pellicle membrane and mask scan surface for electro-static conduction.

Example 33 includes the subject matter of any of examples 30-32, and wherein the one or more assembly mounts include conductive fasteners to be adhered to the mask through a conductive adhesive.

Example 34 includes the subject matter of any of examples 30-33, and wherein the conductive adhesive includes a binder with conductive filler particles.

Example 35 includes the subject matter of any of examples 30-34, and wherein the conductive filler particles include silver particles or platinum group metal particles.

Example 36 includes the subject matter of any of examples 30-35, and wherein the conductive filler particles include material particles coated with a platinum group metal film.

Example 37 includes the subject matter of any of examples 30-36, and wherein the one or more assembly mounts include conductive stud/fixture pair fasteners.

Example 38 includes the subject matter of any of examples 30-37, and wherein a stud from the stud/fastener pair is to be adhered to the mask, and a fastener from the stud/fastener pair is part of the pellicle assembly.

Example 39 includes the subject matter of any of examples 30-38, and wherein the membrane is mounted to a frame that is to be connected to the photomask through the assembly mounts.

Example 40 includes the subject matter of any of examples 30-39, and wherein the frame is formed from a substrate used to build the membrane.

Example 41 includes the subject matter of any of examples 30-40, and wherein the membrane is mounted to a border structure that is mounted to a frame through conductive adhesive mounts, the frame to be connected to the photomask through the assembly mounts.

Example 42 includes the subject matter of any of examples 30-41, and wherein the border is formed from a substrate used to build the membrane.

As used in this specification, the term "embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The terms "substantially," "close," "approximately," "near," and "about," generally refer to being within +/-10% of a target value.

Unless otherwise specified the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

The foregoing has outlined features of several embodiments so that those skilled in the art may better understand the detailed description that follows. Those skilled in the art should appreciate that they may readily use the present disclosure as a basis for designing or modifying other processes and structures for carrying out the same purposes and/or achieving the same advantages of the embodiments disclosed herein. Those skilled in the art should also realize that such equivalent constructions do not depart from the spirit and scope of the present disclosure, and that they may make various changes, substitutions, and alterations herein without departing from the spirit and scope of the present disclosure. For example, the methods and photomasks disclosed herein are applicable to all pattern split methods currently available in DPL technology or pattern split methods available in future developed patterning processes that utilize multiple photomasks. Further, the methods and photomasks disclosed herein may be utilized in other types of lithography apparatuses such as an immersion lithography apparatus.

The following section of the description relates to further examples. The numbered paragraphs in this section are not claims. The claims are set forth below in the later section headed "claims".
1. An apparatus, comprising: a pellicle assembly having a membrane and to be mounted to a photomask (mask) having a scan surface with an outer region; one or more assembly mounts to attach the pellicle assembly to the mask at the outer region, wherein the one or more assembly mounts facilitate sufficient electrical conductivity between the pellicle membrane and mask scan surface to at least be electro statically dissipative between the mask and pellicle assembly when they are attached.
2. The apparatus of clause 1, wherein the one or more assembly mounts include conductive fasteners to be adhered to the mask at the outer region through a conductive adhesive.
3. The apparatus of clause 2, wherein the conductive adhesive includes a binder with conductive filler particles.
4. The apparatus of clause 3, wherein the conductive filler particles include silver particles or platinum group metal particles.
5. The apparatus of clause 3, wherein the conductive filler particles include material particles coated with a platinum group metal film.
6. The apparatus of clause 2, wherein the one or more assembly mounts include conductive stud/fixture pair fasteners.
7. The apparatus of clause 6, wherein a stud from the stud/fastener pair is to be adhered to the mask, and a fastener from the stud/fastener pair is part of the pellicle assembly.
8. The apparatus of clause 1, wherein the pellicle assembly includes a frame that is formed from a substrate used to build the membrane.
9. The apparatus of clause 1, wherein the membrane is mounted to a border structure that is mounted to a frame through conductive adhesive mounts, the frame to be connected to the photomask outer region through the assembly mounts.
10. The apparatus of clause 9, wherein the border is formed from a substrate used to build the membrane.
11. An apparatus, comprising: a photomask having a scan surface; and a pellicle assembly having a membrane, the pellicle assembly mountable to the photomask to pass EUV light through the membrane to the scan surface, wherein the pellicle assembly is mountable to the photomask through one or more assembly mounts, wherein there is sufficient electrical conductivity between the pellicle membrane and mask scan surface to at least be electro statically dissipative between the mask and pellicle assembly when the pellicle assembly is mounted to the photomask.
12. The apparatus of clause 11, wherein the one or more assembly mounts include conductive fasteners to be adhered to the mask through a conductive adhesive.
13. The apparatus of clause 12, wherein the conductive adhesive includes a binder with conductive filler particles.
14. The apparatus of clause 13, wherein the conductive filler particles include silver particles or platinum group metal particles.
15. The apparatus of clause 12, wherein the one or more assembly mounts include conductive stud/fixture pair fasteners.
16. The apparatus of clause 11, wherein the membrane is mounted to a border structure that is mounted to a frame through conductive adhesive mounts, the frame to be connected to the photomask through the assembly mounts.
17. A system, comprising: a photomask (mask) having a pellicle assembly, wherein the mask has a scan surface, and the pellicle assembly has a membrane, the pellicle assembly mounted to the mask to pass EUV light through the membrane to the mask scan surface, the pellicle assembly being mounted to the mask through one or more assembly mounts, wherein there is sufficient electrical conductivity between the pellicle membrane and mask scan surface for electro-static dissipation; an EUV radiation source; an illuminator to illuminate the EUV radiation through the membrane onto the mask scan surface; and a wafer platform to support a semiconductor wafer to be scanned with radiation from the photo optics box.
18. The system of clause 17, further comprising a photo optics box to receive radiation reflected from the photomask and to direct it onto the mask scan surface.
19. The system of clause 18, wherein the one or more assembly mounts include conductive fasteners to be adhered to the mask through a conductive adhesive.
20. The system of clause 19, wherein the conductive adhesive includes a binder with conductive filler particles.

## Claims

1. An apparatus, comprising:
a photomask having a scan surface with an outer region; and
a pellicle assembly having a membrane, the pellicle assembly mountable to the photomask at the outer region to pass EUV light through the membrane to the scan surface, wherein the pellicle assembly is mountable to the photomask through one or more assembly mounts, wherein there is sufficient electrical conductivity between the pellicle membrane and mask scan surface for electro static dissipation between the mask and pellicle assembly when the pellicle assembly is mounted to the photomask.

2. The apparatus of claim 1, wherein the assembly mounts facilitate sufficient conductivity between the mask and pellicle assembly to achieve electrical conductivity between the mask and pellicle assembly.

3. The apparatus according to claims 1 or 2, wherein the one or more assembly mounts include conductive fasteners to be adhered to the mask at the outer region through a conductive adhesive.

4. The apparatus of claim 3, wherein the conductive adhesive includes a binder with conductive filler particles.

5. The apparatus of claim 4, wherein the conductive filler particles include silver particles or platinum group metal particles.

6. The apparatus of claim 4, wherein the conductive filler particles include material particles coated with a platinum group metal film.

7. The apparatus according to any of claims 3-6, wherein the one or more assembly mounts include conductive stud/fixture pair fasteners.

8. The apparatus of claim 7, wherein a stud from the stud/fastener pair is to be adhered to the mask, and a fastener from the stud/fastener pair is part of the pellicle assembly.

9. The apparatus according to any of claims 1-8, wherein the membrane is mounted to a frame that is to be connected to the photomask outer region through the assembly mounts.

10. The apparatus of claim 9, wherein the frame is formed from a substrate used to build the membrane.

11. The apparatus according to any of claims 1-10, wherein the membrane is mounted to a border structure that is mounted to a frame through conductive adhesive mounts, the frame to be connected to the photomask outer region through the assembly mounts.

12. The apparatus of claim 11, wherein the border is formed from a substrate used to build the membrane.

13. The apparatus according to any of claims 1-12, wherein the photomask is an EUV reflector mask.

14. An EUV scan system having an EUV radiation source, an illuminator to illuminate the EUV radiation onto a pellicle/photomask assembly that is in accordance with the apparatus of any of claims 1-13, a photo optics box to receive radiation reflected from the photomask, and a wafer platform to support a semiconductor wafer to be scanned by radiation from the photo optics box.

15. The apparatus according to any of claims 1-13, wherein the membrane includes at least one outer conductive film surface.
